(19)

Europäisches
Patentamt

European
Patent Office

Office européen
des brevets

(11) **EP 2 824 222 A1**

(12) **EUROPEAN PATENT APPLICATION**

(43) Date of publication:
14.01.2015 Bulletin 2015/03

(51) Int Cl.:
*C30B 15/20* (2006.01)          *C30B 15/30* (2006.01)
*C30B 27/02* (2006.01)          *C30B 29/06* (2006.01)
*C30B 30/04* (2006.01)

(21) Application number: 14176279.9

(22) Date of filing: **09.07.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **12.07.2013 JP 2013146005**

(71) Applicant: **GlobalWafers Japan Co., Ltd.
Niigata 957-0197 (JP)**

(72) Inventors:
• **Nagai, Yuta
  Tokyo, 141-0032 (JP)**
• **Nakagawa, Satoko
  Tokyo, 141-0032 (JP)**
• **Kashima, Kazuhiko
  Tokyo, 141-0032 (JP)**

(74) Representative: **Hoffmann Eitle
Patent- und Rechtsanwälte PartmbB
Arabellastraße 30
81925 München (DE)**

(54) **Silicon single crystal and method for manufacture thereof**

(57)     A silicon single crystal manufacturing method includes:
applying a transverse magnetic field to a melt of polysilicon with a carbon concentration of at most $1.0 \times 10^{15}$ atoms/cm$^3$ as a raw material; rotating the crucible at 5.0 rpm or less; allowing inert gas to flow at rate A (m/sec) of formula (1) at a position 20-50% of Y above the melt surface; controlling the rate A within the range of 0.2 to 5, 000/d (m/sec) (d: crystal diameter (mm));
and reducing the total power of side and bottom heaters by 3 to 30% and the side heater power by 5 to 45% until the solidified fraction reaches 30%.

$$A = \left[ \frac{Q \cdot 760}{1000 \cdot 60 \cdot P} \cdot \alpha \right] \Big/ \left[ \pi \cdot X \cdot Y \cdot 10^{-6} \right] \quad \cdot \cdot \cdot \cdot \quad (1)$$

Q: Inert gas volumetric flow rate (L/min)  P: Pressure (Torr) in furnace
X: Radiation shield opening diameter
Y: Distance (mm) from raw material melt surface to radiation shield lower end
$\alpha$ : Correction coefficient

EP 2 824 222 A1

# Fig. 1

**Description**

BACKGROUND OF THE INVENTION

Field of the Invention

The present invention relates to a low-carbon-concentration silicon single crystal, manufactured by Czochralski (hereinafter abbreviated as CZ) method, suitable for silicon substrates for high-voltage IGBT (Insulated Gate Bipolar Transistor), and to a method for manufacturing such a silicon single crystal.

Description of the Related Art

Silicon substrates for IGBT designed to withstand a high voltage of at least 1 kV are usually required to have less crystal defects such as oxygen precipitation nuclei capable of acting as carrier recombination centers and to have a long carrier life time.

The formation of oxygen precipitation nuclei in a silicon single crystal is mainly caused by carbon impurities, and the growth of the oxygen precipitation nuclei formed is influenced by the oxygen concentration of the crystal.

Methods for manufacturing silicon single crystal ingots include CZ methods and FZ (Floating Zone) methods. Silicon single crystals manufactured by FZ methods (hereinafter abbreviated as FZ silicon crystals) have a very low oxygen concentration and hardly allow oxygen precipitation nuclei to grow. Conventionally, therefore, FZ silicon crystals are used as silicon substrates for IGBT.

In contrast, CZ methods have difficulty in reducing oxygen concentration to the same level as that of FZ silicon crystals because CZ methods use a quartz crucible, into which the raw material is charged, so that a significantly large amount of oxygen can intrude from the quartz crucible. In CZ methods, the growth of oxygen precipitation nuclei capable of acting as carrier recombination centers are more likely to be facilitated, and the product has a relatively short carrier life time and thus is not suitable for silicon substrates for high-voltage IGBT.

It is, however, technically difficult to form large-diameter FZ silicon crystals. Therefore, FZ silicon crystals have a problem with mass productivity and cost and can hardly address possible rapid growth of the power device market in the future.

In recent years, therefore, studies have been made about using, as silicon substrates for high-voltage IGBT, silicon single crystals manufactured by CZ methods (hereinafter abbreviated as CZ silicon crystals) with high mass productivity.

As mentioned above, there is a limit to the reduction in the oxygen concentration of CZ silicon crystals. In order to use CZ silicon crystals for IGBT, therefore, it is necessary to reduce the carbon concentration of the crystals to at most $1.0 \times 10^{14}$ atoms/cm$^3$ and to suppress the formation of oxygen precipitation nuclei. It is conceivable that the carbon concentration of the crystals can be reduced by reducing the carbon concentration of the raw material.

Due to the effect of segregation, however, the carbon concentration can increase as the pulling of a silicon single crystal proceeds, and it is difficult to keep the carbon concentration at a level of $1.0 \times 10^{14}$ atoms/cm$^3$ or less over the whole length of the crystal. For example, when polysilicon whose carbon concentration is as low as $5.0 \times 10^{14}$ atoms/cm$^3$ is used as a raw material, the carbon concentration of the crystal is about $3.5 \times 10^{13}$ atoms/cm$^3$, due to the effect of segregation (equilibrium segregation coefficient of carbon: 0.07), during the period from the time when the melting of the raw material is started to the time when the solidified fraction of the pulled crystal is 5% at the start of pulling the crystal body, and the carbon concentration of the crystal increases to $3.0 \times 10^{14}$ atoms/cm$^3$ at the time when the pulling of the body is completed with a solidified fraction of 90%.

In order to keep the carbon concentration at $1.0 \times 10^{14}$ atoms/cm$^3$ or less over the whole length of the crystal, it is desired to reduce the carbon concentration of the raw material to less than $1.0 \times 10^{14}$ atoms/cm$^3$. However, such a polysilicon raw material is very costly to obtain.

It is also known that the carbon concentration of the crystal can be reduced by controlling the rate (amount) of contamination of the raw material melt with CO from a high-temperature graphite component such as a heater, a graphite crucible, or a heat insulator in the furnace and by controlling the rate (amount) of CO evaporation from the raw material melt. The generation of CO from the high-temperature graphite component is caused by the following reaction of SiO evaporated from the raw material melt.

$$\text{SiO (gas)} + 2\text{C (solid)} \rightarrow \text{CO (gas)} + \text{SiC (solid)}$$

For example, therefore, JP 07-89789 A (Patent Literature 1) discloses a method for manufacturing a low-carbon-concentration CZ silicon crystal, in which the surface of a high-temperature graphite component such as a heater or a graphite crucible is coated with SiC or other materials so that the amount of CO generation from the high-temperature graphite component can be reduced.

JP 05-339093 A (Patent Literature 2) discloses a process including the step of heating a silicon melt to a temperature higher than the melting point of silicon in the presence of $SiO_2$ before the start of crystal growth and holding the melt at the temperature for at least 30 minutes so that CO is evaporated from the melt (decarbonizing step).

In the method disclosed in Patent Literature 1, however, the coating such as SiC on the high-temperature graphite component is very expensive. In addition, the SiC coating may peel off after several pulling processes because the side heater around the crucible reaches a very high temperature, which makes the method unsuitable for mass production.

Additionally in this method, the carbon concentration of the crystal can reach $1.0 \times 10^{14}$ atoms/cm$^3$ or more when the solidified fraction of the crystal is 55% or more, so that the yield of the crystal suitable for use in high-voltage IGBT can be poor. When the oxygen concentration is $1.3 \times 10^{18}$ atoms/cm$^3$ or more in this method, oxygen precipitation nuclei can be grown, which makes the crystal unsuitable for silicon substrates for high-voltage IGBT.

In the method disclosed in Patent Literature 2 , an increase in heater power is necessary for heating the silicon melt and holding it at high temperature. Therefore, the rate of contamination of the silicon melt with CO can be higher than the rate of CO evaporation from the silicon melt, so that the carbon concentration of the crystal being pulled may rather increase.

In addition, the rate of CO evaporation from the silicon melt is far lower than the rate of SiO evaporation from the silicon melt. Even if the rate of CO evaporation from the silicon melt becomes higher than the rate of contamination of the silicon melt with CO, the decarbonizing step must be performed for a very long time in order to reduce the carbon concentration of the crystal to $1 \times 10^{14}$ atoms/cm$^3$ or less, which can lead to lower productivity.

<u>SUMMARY OF THE INVENTION</u>

The present invention has been made to solve the technical problems described above. It is an object of the present invention to provide, by a CZ method, a low-carbon-concentration silicon single crystal suitable for use as a silicon substrate for high-voltage IGBT and to provide a method for manufacturing such a silicon single crystal.

The present invention is directed to a method for manufacturing a silicon single crystal comprising: preparing polysilicon with a carbon concentration of at most $1.0 \times 10^{15}$ atoms/cm$^3$ as a raw material and melting the raw material charged into a quartz crucible to form a raw material melt; applying a transverse magnetic field to the raw material melt; rotating the quartz crucible charged with the raw material melt at a speed of at most 5.0 rpm when pulling a silicon single crystal by a Czochralski method; allowing an inert gas to flow at a rate A (m/sec) at a position in the range from 20 to 50% of the distance Y from a surface of the raw material melt to a lower end of a radiation shield, wherein the rate A is expressed by formula (1) below; controlling the rate A within the range of 0.2 to 5,000/d (m/sec), wherein d (mm) is a diameter of a body of the pulled crystal, during at least a period from a time when the meltingof the rawmaterial is started to a time when the solidified fraction of the pulled crystal reaches 30%; and reducing the total power of a side heater and a bottom heater by a rate of 3 to 30%, and reducing power of the side heater by a rate of 5 to 45%, respectively, during a period from a time when a seed crystal is brought into contact with a the raw material melt to a time when the solidified fraction of the pulled crystal reaches 30%.

[Mathematical Formula 1]

$$A = \left[ \frac{Q \cdot 760}{1000 \cdot 60 \cdot P} \cdot \alpha \right] \Big/ \left[ \pi \cdot X \cdot Y \cdot 10^{-6} \right] \quad \cdot \cdot \cdot \cdot \quad (1)$$

wherein Q is the flow rate (L/min) of the inert gas,
P is the pressure (Torr) in the furnace,
X is the diameter (mm) of the opening of a radiation shield,
Y is the distance (mm) from the surface of the raw material melt to the lower end of the radiation shield, and
$\alpha$ is a correction coefficient.

Under these crystal-pulling conditions, a CZ silicon crystal having a low carbon concentration of at most $1.0 \times 10^{14}$ atoms/cm$^3$ over the whole length of its body can be conveniently manufactured at low cost with high productivity.

In the silicon single crystal manufacturing method, the flow rate Q of the inert gas is preferably from 50 to 200 L/min, the pressure P in the furnace is preferably from 5 to 100 Torr, the diameter X of the opening of the radiation shield is preferably from d + 20 (mm) to d + 50 (mm), and the distance Y from the surface of the raw material melt to the lower end of the radiation shield is preferably from 10 to 40 mm.

Under such conditions, the rate of CO evaporation from the raw material melt can be easily made higher than the rate of contamination of the raw material melt with CO, and a dislocation-free crystal can be grown with higher productivity.

The present invention is also directed to a silicon single crystal obtained by the above manufacturing method. Thesilicon single crystal includes a crystal body having a carbon concentration of at most $1.0 \times 10^{14}$ atoms/cm$^3$ at least by a time when the solidified fraction of the pulled crystal reaches 90%, and having a minimum value on its carbon concentration distribution plotted against the solidified fraction.

In such a silicon single crystal, oxygen precipitation nuclei capable of acting as carrier recombination centers are reduced, and the growth of the oxygen precipitation nuclei is also suppressed. Therefore, such a silicon single crystal is suitable for use as a silicon substrate for high-voltage IGBT.

The silicon single crystal preferably has an oxygen concentration of at most $1.0 \times 10^{18}$ atoms/cm$^3$.

To be suitable for use as a silicon substrate for IGBT, the silicon single crystal preferablyhas an oxygen concentration as low as possible.

In addition, the silicon single crystal preferably has a minimum value on its carbon concentration distribution plotted against the solidified fraction, and the minimum value preferably appears until the time when the solidified fraction reaches 30%.

Such a silicon single crystal can have a much lower carbon concentration over the whole length of the crystal body.

The carbon concentration is preferably determined by a photoluminescence (PL) method.

Even low carbon concentrations of $1.0 \times 10^{14}$ atoms/cm$^3$ or less can be accurately determined using the PL method.

The CZ method according to the present invention makes it possible to keep the amount of CO evaporation from the raw material melt larger than the amount of contamination of the raw material melt with CO during the melting of the raw material and during the crystal growth. Thus, the present invention makes it possible to provide a method capable of manufacturing, at low cost with high productivity, a silicon single crystal having a carbon concentration of at most $1.0 \times 10^{14}$ atoms/cm$^3$ over the whole length of the crystal body.

The silicon single crystal obtained by the manufacturing method according to the present invention has a low carbon concentration as stated above and therefore is suitable for use as a silicon substrate for high-voltage IGBT.

BRIEF DESCRIPTION OF THE DRAWING

FIG. 1 is a schematic cross-sectional view of an example of an apparatus for pulling a single crystal by CZ method;
FIG. 2 is a graph showing the relationship between the solidified fraction and carbon concentration of the crystal according to Example 1;
FIG. 3 is a graph showing the relationship between the solidified fraction and carbon concentration of the crystal according to Example 2;
FIG. 4 is a graph showing the relationship between the solidified fraction and oxygen concentration of the crystals according to Examples 1 and 2;
FIG. 5 is a graph showing the relationship between the solidified fraction and carbon concentration of the crystal according to Comparative Example 1; and
FIG. 6 is a graph showing the relationship between the solidified fraction and carbon concentration of the crystal according to Comparative Example 3.

DESCRIPTION OF THE PREFERRED EMBODIMENTS

Hereinafter, the present invention will be more specifically described with reference to the drawings.

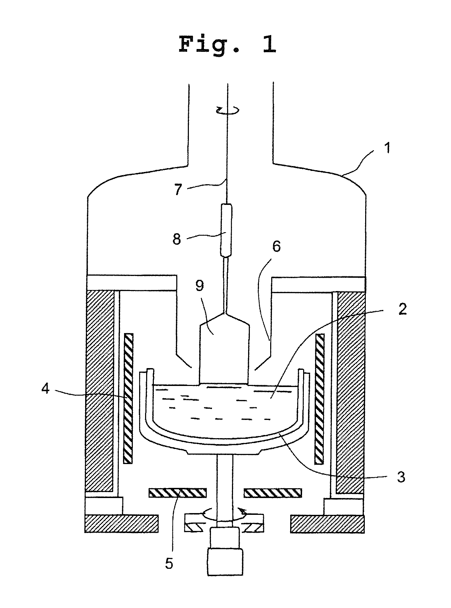

Fig. 1 schematically shows an example of an apparatus for pulling a single crystal by CZ method, which is suitable for use in the manufacturing method according to the present invention. The pulling apparatus shown in Fig. 1 has a common structure including a furnace 1, a quartz crucible 3 that is rotatably placed at the center inside the furnace 1 and charged with a rawmaterial melt 2, a side heater 4 for heating the crucible 3 from the surrounding side, and a bottom heater 5 for heating the crucible 3 from the bottom. The apparatus further includes a radiation shield 6 that is provided above the quartz crucible 3 to control the temperature of the surface of the raw material melt in the crucible 3 and the temperature of the crystal being pulled. For the prevention of impurity contamination and other purposes, the furnace 1 contains an inert gas atmosphere.

A seed crystal 8 held at the lower end of a wire 7 is brought into contact with the surface of the raw material melt 2 in the quartz crucible 3. A crystal 9 is grown by pulling the wire 7 while rotating the quartz crucible 3 and the seed crystal 8, respectively.

In the present invention, the crystal 9 being pulled preferably has a body diameter d of 150 to 450 mm.

The method for manufacturing a silicon single crystal according to the present invention relates to a method for pulling a silicon single crystal by CZ method as shown above. The method is characterized in that the pulling is performed under the following conditions. Polysilicon with a carbon concentration of $1.0 \times 10^{15}$ atoms/cm$^3$ or less is used as a raw material. A transverse magnetic field is applied to a melt of the raw material. The quartz crucible charged with the raw material melt is rotated at a speed of 5.0 rpm or less. An inert gas is allowed to flow in such a way that the flow rate A of the inert gas at a position in the range from 20 to 50% of the distance Y from the surface of the raw material melt to the lower end of the radiation shield is expressed by formula (1) above and set within a specific range. In addition, the power of the side heater and the power of the bottom heater are each decreased by a specific rate.

This manufacturing method makes it possible to facilitate the evaporation of CO from the raw material melt during the process of melting the raw material and pulling the crystal and thus to conveniently produce a low-carbon-content CZ silicon crystal, which has a carbon concentration of $1.0 \times 10^{14}$ atoms/cm$^3$ or less over the whole length of its body, at low cost with high productivity without any improvement of a costly component, such as a coating on a high-temperature graphite component, in the furnace of the singly crystal pulling apparatus.

In the manufacturing method according to the present invention, the flow rate A of the inert gas above the surface of the raw material melt is expressed by formula (1) above, in which Q is the flow rate of the inert gas, P is the pressure in the furnace, X is the diameter of the opening of the radiation shield, Y is the distance from the surface of the raw material melt to the lower end of the radiation shield, and $\alpha$ is a correction coefficient. The correction coefficient $\alpha$ is a coefficient for the correction of the effect of the temperature and the interior structure of the furnace.

During at least the period from the time when the melting of the raw material is started to the time when the solidified fraction of the pulled crystal reaches 30%, the flow rate Q of the inert gas, the pressure P in the furnace, the diameter X of the opening of the radiation shield, and the distance Y from the surface of the raw material melt to the lower end of the radiation shield are controlled in such a way that the flow rate A falls within the range of 0.2 to 5,000/d (m/sec) (d: the body diameter (mm) of the crystal).

When the flow rate of the inert gas in the furnace is controlled in this way, the raw material melt can be prevented from being contaminated with CO which is generated and diffused from a high-temperature graphite component, such as a heater, a graphite crucible, or a heat insulator, in the furnace.

The inert gas to be used may be helium, argon, or the like. Argon is usually used.

The flow rate A of the inert gas is defined as the flow rate of the gas at a position in the range from 20 to 50% of the distance Y from the surface of the raw material melt to the lower end of the radiation shield. In particular, the flow rate A is preferably a flow rate at a position immediately below the lower end of the radiation shield.

When the flow rate at such a position is controlled as described above, the raw material melt can be more effectively prevented from being contaminated with CO being diffused from a high-temperature graphite component, and CO being evaporated from the melt can be quickly discharged, so that the evaporation rate can be made higher than the contamination rate.

If the flow rate A is defined as a rate at a position less than 20% of Y or more than 50% of Y from the surface of the raw material melt, the efficiency of discharge of CO evaporated from the melt will decrease, which can make it difficult to control the rate of contamination (the amount of contamination) with CO or the CO evaporation rate (evaporation amount).

If the flow rate A is less than 0.2 m/sec, the rate (amount) of contamination of the raw material melt with CO can be higher than the rate (amount) of CO evaporation from the melt, so that the carbon concentration can increase. On the other hand, if the flow rate A is more than 5,000/d (m/sec), the flow rate of the inert gas immediately above the raw material melt can be too high, so that the influence on the crystal being pulled, such as vibration, can increase, which can make it difficult to grow a dislocation-free crystal.

The flow rate Q of the inert gas is preferably from 50 to 200 L/min.

If it is less than 50 L/min, CO generated from the high-temperature graphite component can be more diffused to the surface of the raw material melt, so that the rate of contamination of the raw material melt with CO can tend to be constantly higher than the rate of CO evaporation from the melt. On the other hand, if it is more than 200 L/min, the crystal manufacturing cost may increase, and melt surface vibration or crystal swinging may increase, which may make it difficult to grow a dislocation-free crystal.

The pressure P in the furnace is preferably from 5 to 100 Torr.

If it is less than 5 Torr, the flow rate of the gas immediately above the raw material melt may increase, and melt surface vibration or crystal swinging may increase, which may make it difficult to grow a dislocation-free crystal. On the other hand, if it is more than 100 Torr, CO can be more diffused to the surface of the raw material melt, so that the rate of contamination of the raw material melt with CO can tend to be higher than the rate of CO evaporation from the melt.

The diameter X of the opening of the radiation shield is preferably from d + 20 (mm) to d + 50 (mm).

If X is less than d + 20 (mm), the gas can flow at a higher rate through the space between the crystal surface and the radiation shield, so that the crystal may swing during the growth, which may cause the crystal to contact the radiation shield. On the other hand, if X is more than d + 50 (mm), the thermal environment may be unstable during the crystal growth, which may make it difficult to grow a dislocation-free crystal.

The distance Y from the surface of the raw material melt to the lower end of the radiation shield is preferably from 10 to 40 mm.

If Y is less than 10 mm, the flow rate of the gas immediately above the raw material melt may increase, and melt surface vibration or crystal swinging may increase, which may make it difficult to grow a dislocation-free crystal. On the other hand, if Y is more than 40 mm, the flow rate of the gas immediately above the raw material melt can be low so that CO can be more diffused to the surface of the raw material melt and the rate of contamination of the raw material melt with CO can tend to be higher than the rate of CO evaporation from the melt.

In the manufacturing method according to the present invention, heating by a heater is controlled. Specifically, the total power of the side heater and the bottom heater and the power of the side heater are reduced by a rate of 3 to 30% and by a rate of 5 to 45%, respectively, during the period from the time when the seed crystal is brought into contact with the raw material melt to the time when the solidified fraction of the pulled crystal reaches 30%.

When the power of the heaters for heating the inside of the furnace and the raw material melt is controlled in this way, the rate of CO evaporation from the raw material melt can be made higher than the rate of contamination of the raw material melt with CO during the crystal growth, so that the melt can be prevented from being contaminated with CO, which makes it possible to reduce the carbon concentration of the crystal to at most $1.0 \times 10^{14}$ atoms/cm$^3$ over the whole length of the crystal body.

If the total power of the side heater and the bottom heater is reduced by a rate of less than 3% or if the power of the side heater is reduced by a rate of less than 5%, the rate (amount) of contamination of the rawmaterial melt with CO cannot be reduced, and the rate (amount) of CO evaporation from the raw material melt cannot be made higher than the rate (amount) of contamination of the melt with CO. On the other hand, if the total power is reduced by a rate of more than 30% or if the power of the side heater is reduced by a rate of more than 45%, the temperature of the raw material melt will decrease too much, so that crystal deformation or other defect can occur, which makes it difficult to grow a dislocation-free crystal.

The control of the inert gas flow rate A and the control of the heater power described above are performed at least until the solidified fraction of the pulled crystal reaches 30%.

If the control of the inert gas flow rate A and the control of the heater power described above are stopped at the time when the solidified fraction of the crystal is less than 30%, it will be difficult to reduce the carbon concentration of the crystal to at most $1.0 \times 10^{14}$ atoms/cm$^3$ over the whole length of the crystal body.

Polysilicon as the raw material has a carbon concentration of at most $1.0 \times 10^{15}$ atoms/cm$^3$.

The use of such a raw material makes it possible to keep CO evaporation dominant during the melting of the raw material and during the crystal growth, so that the carbon concentration of the crystal can be reduced to at most $1.0 \times 10^{14}$ atoms/cm$^3$ over the whole length of the crystal body.

If polysilicon as the raw material has a carbon concentration of more than $1.0 \times 10^{15}$ atoms/cm$^3$, it will take a very long time to reduce the carbon concentration of the raw material melt to at most $1.0 \times 10^{14}$ atoms/cm$^3$. This is because the rate of CO evaporation is far lower than the rate of SiO evaporation even when the rate of CO evaporation from the raw material melt is higher than the rate of contamination of the melt with CO.

A transverse magnetic field is applied to the raw material melt.

The magnetic field suppresses the convection of the raw material melt, so that the leaching of oxygen from the quartz crucible is suppressed, which makes it possible to reduce the oxygen concentration of the crystal to at most $1.0 \times 10^{18}$ atoms/cm$^3$.

The quartz crucible charged with the raw material melt is rotated at a speed of 5.0 rpm or less.

If the rotation speed of the quartz crucible is more than 5.0 rpm, a larger amount of oxygen can leach from the quartz crucible which makes it difficult to obtain a crystal with an oxygen concentration of $1.0 \times 10^{18}$ atoms/cm$^3$ or less.

As described above, the manufacturing method according to the present invention can manufacture a crystal at low cost with high productivity and makes it possible to keep the amount of CO evaporation from the melt higher than the amount of contamination of the melt with CO during the melting of the raw material and during the crystal growth. This makes it possible to provide a CZ silicon single crystal that has a carbon concentration of at most $1.0 \times 10^{14}$ atoms/cm$^3$ over the whole length of its body with a solidified fraction of up to 90%, has a minimum value on its carbon concentration distribution plotted against the solidified fraction of the pulled crystal, and also has an oxygen concentration of at most $1.0 \times 10^{18}$ atoms/cm$^3$.

In such a silicon single crystal, oxygen precipitation nuclei capable of acting as carrier recombination centers are reduced, and the following growth of such nuclei is also suppressed. Therefore, such a silicon single crystal is suitable for use as a silicon substrate for high-voltage IGBT.

The silicon single crystal preferably has a minimum value on its carbon concentration distribution plotted against the solidified fraction until the solidified fraction reaches 30%.

When such a carbon concentration distribution is achieved, the carbon concentration of the crystal can be further reduced over the whole length of the crystal body.

In the present invention, the carbon concentration of the silicon single crystal is preferably determined by photoluminescence (PL) method.

FT-IR (Fourier Transform Infrared Spectroscopy) method is a predominant technique for analyzing the carbon concentration of a silicon single crystal. However, FT-IR method has a lower carbon detection limit of approximately $2.0 \times 10^{15}$ atoms/cm$^3$, and thus has difficulty in accurately evaluating the carbon concentration of the silicon single crystal according to the present invention.

Charged particle activation analysis is known to be capable of evaluating carbon concentrations lower than those evaluated by FT-IR method. However, this technique has a lower detection limit of approximately $2.0 \times 10^{14}$ atoms/cm$^3$, and is also not suitable for the evaluation of the low carbon concentration of the silicon single crystal according to the present invention.

In the present invention, it is necessary to accurately determine carbon concentrations equal to or lower than $1.0 \times 10^{14}$ atoms/cm$^3$ in order to obtain a silicon single crystal with a lower carbon concentration. Therefore, PL method is advantageously used for the evaluation because it is reported as a technique for evaluating the extremely low concentration (approximately $1.0 \times 10^{13}$ atoms/cm$^3$) of carbon in a silicon single crystal (see S. Nakagawa, K. Kashima, and M. Tajima, Proceedings of the Forum on the Science and Technology of Silicon Materials, 2010 (2010), 326).

Hereinafter, the present invention will be more specifically described with reference to examples. It will be understood, however, that the examples below are not intended to limit the present invention.

[Example 1]

Using a single crystal puller by a CZ method as shown in Fig. 1, ten silicon single crystals were each pulled in such away that the crystal had a body diameter of 200 mm and a solidified fraction of 90% at the time when the pulling of the body portion was completed.

The raw material used was polysilicon with a carbon concentration of about $5.0 \times 10^{14}$ atoms/cm$^3$.

The pulling conditions were as follows. During the pulling of the crystal, a transverse magnetic field was applied to the raw material melt. The speed of the rotation of the quartz crucible charged with the rawmaterial melt was controlled within the range of 0.1 to 1.0 rpm, and the crystal rotation speed was controlled within the range of 15 to 25 rpm. The crystal body was pulled at a rate of 1.0 to 1.3 mm/min. The effective segregation coefficient was 0.082, which was calculated taking these operating conditions into account.

The flow rate Q of the argon gas was 150 L/min, and the pressure P in the furnace was 30 Torr. The diameter X of the opening of the radiation shield was 240 mm, and the distance Y from the surface of the raw material melt to the lower end of the radiation shield was 20 mm. The argon gas was allowed to flow at a rate A, which is expressed by formula (1), at a position 4 to 10 mm above the surface of the raw material melt. The flow rate A was controlled to fall within the range of 0.2 to 20 m/sec during at least the period from the time when the melting of the raw material was started to the time when the solidified fraction of the pulled crystal reached 30%.

In addition, the total power of the side heater and the bottom heater was reduced by a rate of 22%, and the power of the side heater was reduced by a rate of 36%, during the period from the time when the seed crystal was brought into contact with the rawmaterial melt to the time when the solidified fraction of the pulled crystal reached 30%.

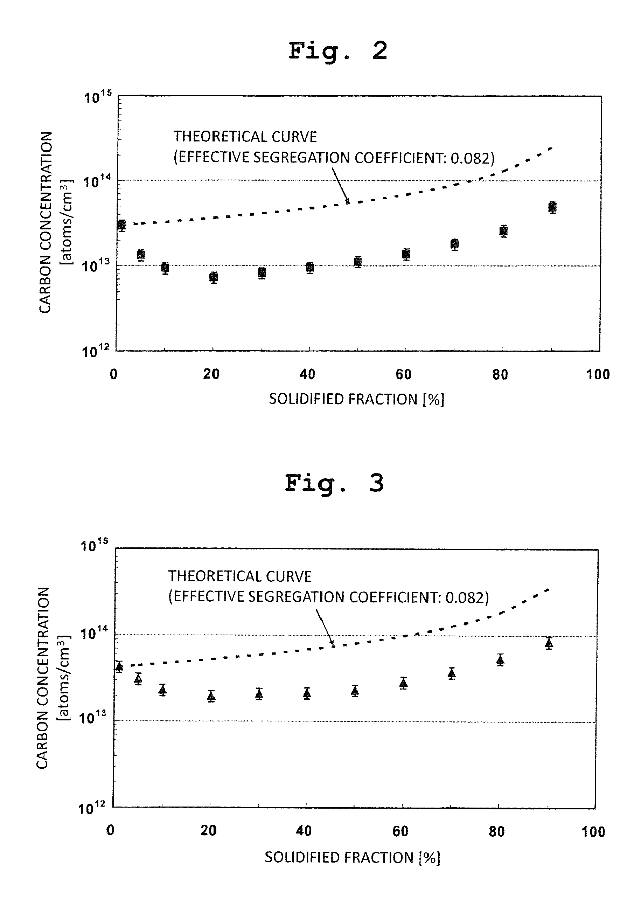

In total, 11 samples for evaluation were cut from the crystal pulled as described above. The samples were cut from sites where the solidified fraction was 1%, 5%, 10%, 20%, 30%, 40%, 50%, 60%, 70%, 80%, and 90% (at intervals of 10% in the range of 10 to 90%), respectively. The carbon concentration of each sample was measured by photoluminescence method. Fig. 2 is a graph showing the relationship between the measured carbon concentration and the solidified fraction. Fig. 2 also shows a theoretical curve for the change in carbon concentration against solidified fraction based on the effective segregation coefficient.

For all the 10 pulled crystals, a reduction in carbon concentration caused by the evaporation of CO from the raw material melt was observed in the solidified fraction range of 5 to 30%, and the distribution of carbon concentration plotted against solidified fraction had a minimum value at a solidified fraction of about 30%. The carbon concentration of the crystal at the time when the pulling of the crystal body was completed with a solidified fraction of 90% was in the range of $4.1 \times 10^{13}$ to $5.6 \times 10^{13}$ atoms/cm$^3$, and the carbon concentration of the crystal was $1.0 \times 10^{14}$ atoms/cm$^3$ or less over the whole length of the crystal body.

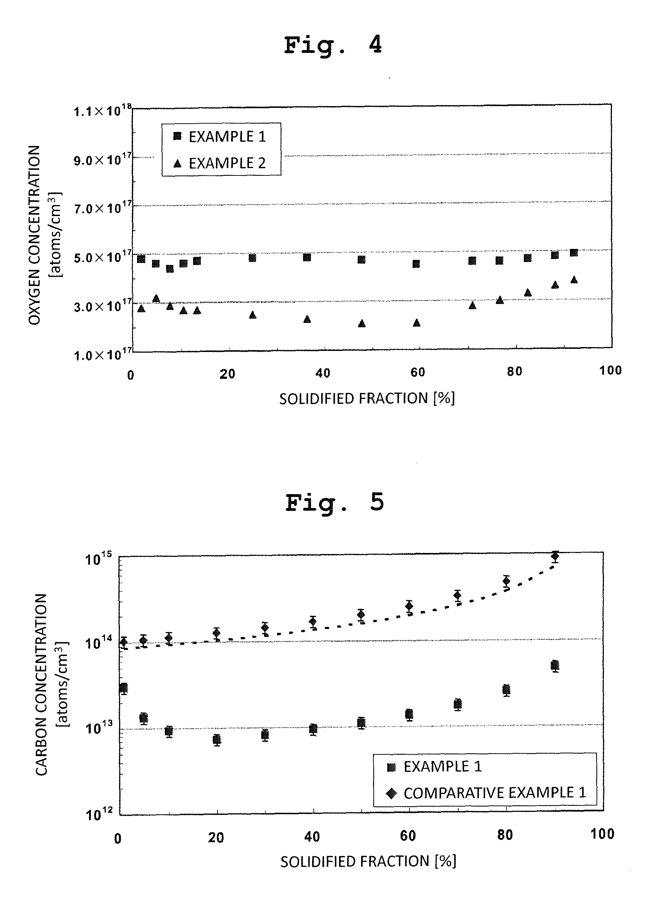

The oxygen concentration was also measured by FT-IR method at the same sites as in the measurement of the carbon concentration. Fig. 4 is a graph showing the relationship between the measured oxygen concentration and the solidified fraction.

The oxygen concentration of the crystal was in the range of $4.4 \times 10^{17}$ to $5.0 \times 10^{17}$ atoms/cm$^3$ over the whole length of the crystal body.

[Example 2]

The distance Y from the surface of the raw material melt to the lower end of the radiation shield was 40 mm. The flow rate Q of the argon gas was 80 L/min, and the pressure P in the furnace was 50 Torr. The diameter X of the opening of the radiation shield was 250 mm. The argon gas was allowed to flow at a rate A of 0.2 to 25 m/sec at a position 8 to 20 mm above the surface of the raw material melt during at least the period from the time when the melting of the raw material was started to the time when the solidified fraction of the pulled crystal reached 30%. In addition, the total power of the side heater and the bottom heater was reduced by a rate of 9%, and the power of the side heater was reduced by a rate of 13%, during the period from the time when the seed crystal was brought into contact with the rawmaterial melt to the time when the solidified fraction of the pulled crystal reached 30%. Ten silicon single crystals were pulled under the same conditions as in Example 1, except for the above, and the carbon concentration of the crystals was measured as in Example 1. Fig. 3 is a graph showing the relationship between the measured carbon concentration and the solidified fraction. Fig. 3 also shows a theoretical curve for the change in carbon concentration against solidified fraction based on the effective segregation coefficient.

For all the 10 pulled crystals, a reduction in carbon concentration caused by the evaporation of CO from the raw material melt was observed in the solidified fraction range of 5 to 30%, and the distribution of carbon concentration plotted against solidified fraction had a minimum value at a solidified fraction of about 30%. The carbon concentration of the crystal at the time when the pulling of the crystal body was completed with a solidified fraction of 90% was in the range of $7.1 \times 10^{13}$ to $9.6 \times 10^{13}$ atoms/cm$^3$, and the carbon concentration of the crystal was $1.0 \times 10^{14}$ atoms/cm$^3$ or less over the whole length of the crystal body.

The oxygen concentration was also measured by FT-IR method at the same sites as in the measurement of the carbon concentration. Fig. 4 is a graph showing the relationship between the measured oxygen concentration and the solidified fraction.

The oxygen concentration of the crystal was in the range of $2.2 \times 10^{17}$ to $4.0 \times 10^{17}$ atoms/cm$^3$ over the whole length of the crystal body.

[Comparative Example 1]

Ten silicon single crystals were pulled and the carbon concentration was measured as in Example 1, except that the argon gas was allowed to flow at a rate A of less than 0.2 m/sec at a position 4 to 10 mm above the surface of the raw material melt during the period from the time when the melting of the rawmaterial was started to the time when the solidified fraction of the pulled crystal reached 30%. Fig. 5 shows a graph showing the relationship between the measured carbon concentration and the solidified fraction. For comparison, Fig. 5 also shows the measured values in Example 1.

The carbon concentration of these crystals was higher than $1.0 \times 10^{14}$ atoms/cm$^3$ from the start of the pulling of the crystal body. Any reduction in carbon concentration caused by the evaporation of CO from the raw material melt was not observed even after the pulling proceeded, and the concentration constantly stayed higher than the theoretical curve for the effective segregation coefficient. This would be because the gas flow rate was very low during the melting of the raw material and the pulling of the crystal so that the melt was constantly contaminated with CO.

[Comparative Example 2]

Ten silicon single crystals were pulled and the carbon concentration was measured as in Example 1, except that the argon gas was allowed to flow at a rate A of more than 25 m/sec at a position 4 to 10 mm above the surface of the raw material melt during the period from the time when the melting of therawmaterial was started to the time when the solidified fraction of the pulled crystal reached 30%. In all the cases, however, melt surface vibration was very high during the pulling, and crystal deformation occurred at the time when the solidified fraction was at most 50% so that no dislocation-free crystal was able to be grown.

[Comparative Example 3]

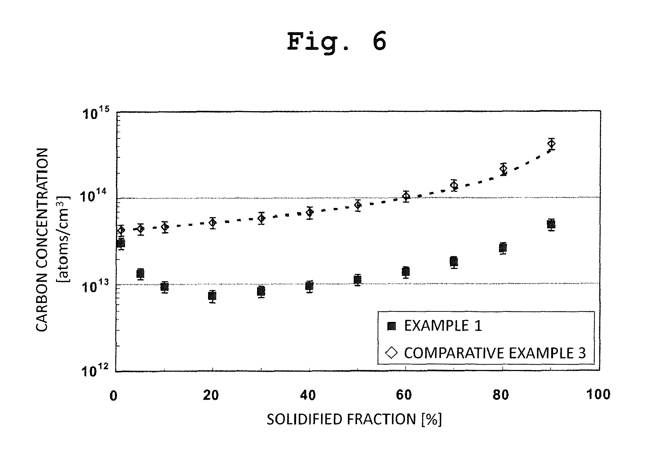

Ten silicon single crystals were pulled and the carbon concentration was measured as in Example 1, except that the total power of the side heater and the bottom heater was reduced by a rate of less than 3%, and the power of the side heater was reduced by a rate of less than 5%, during the period from the time when the seed crystal was brought into contact with the raw material melt to the time when the solidified fraction of the pulled crystal reached 30%. Fig. 6 shows a graph showing the relationship between the measured carbon concentration and the solidified fraction. For comparison, Fig. 5 also shows the measured values in Example 1.

The carbon concentration of these crystals was substantially the same as that of the crystals in Example 1 when the pulling of the crystal body was started. However, no evaporation was observed by the time when the pulling of the crystal body was completed with a solidification fraction of 90%, and the carbon concentration exceeded $1.0 \times 10^{14}$ atoms/cm$^3$ when the solidified fraction was around 60%. This would be because the power of the side heater was little reduced during the period from the time when the seed crystal was brought into contact with the raw material melt to the time when the solidified fraction reached 30%, so that the rate of CO evaporation from the raw material melt did not become higher than the rate of contamination of the melt with CO during the crystal growth.

[Comparative Example 4]

Ten silicon single crystals were pulled as in Example 1, except that the total power of the side heater and the bottom heater was reduced by a rate of more than 30%, and the power of the side heater was reduced by a rate of more than 45%, during the period from the time when the seed crystal was brought into contact with the raw material melt to the time when the solidified fraction of the pulled crystal reached 30%. In all the cases, however, crystal deformation occurred at the time when the solidified fraction was around 30%, and no dislocation-free crystal was able to be grown.

**Claims**

1. A method for manufacturing a silicon single crystal comprising:

preparing polysilicon with a carbon concentration of at most $1.0 \times 10^{15}$ atoms/cm$^3$ as a raw material and melting the raw material charged into a quartz crucible to form a raw material melt;
applying a transverse magnetic field to the raw material melt;
rotating the quartz crucible charged with the raw material melt at a speed of at most 5.0 rpm when pulling a silicon single crystal by a Czochralski method;
allowing an inert gas to flow at a rate A (m/sec) at a position in the range from 20 to 50% of the distance Y from a surface of the raw material melt to a lower end of a radiation shield, wherein the rate A is expressed by formula (1):
[Mathematical Formula 1]

$$A = \left[ \frac{Q \cdot 760}{1000 \cdot 60 \cdot P} \cdot \alpha \right] \Big/ \left[ \pi \cdot X \cdot Y \cdot 10^{-6} \right] \quad \cdot \cdot \cdot \cdot \quad (1)$$

wherein Q is the flow rate (L/min) of the inert gas, P is the pressure (Torr) in a furnace, X is a diameter (mm) of an opening of a radiation shield, Y is the distance (mm) from the surface of the raw material melt to the lower end of the radiation shield, and $\alpha$ is a correction coefficient;
controlling the rate A within the range of 0.2 to 5, 000/d (m/sec), wherein d (mm) is a diameter of a body of the pulled crystal, during at least a period from a time when the melting of the raw material is started to a time when the solidified fraction of the pulled crystal reaches 30%;
and reducing the total power of a side heater and a bottom heater by a rate of 3 to 30%, and reducing power of the side heater by a rate of 5 to 45%, respectively, during a period from a time when a seed crystal is brought into contact with a the rawmaterial melt to a time when the solidified fraction of the pulled crystal reaches 30%.

2. The method according to claim 1, wherein the flow rate Q of the inert gas is from 50 to 200 L/min, the pressure P in the furnace is from 5 to 100 Torr, the diameter X of the opening of the radiation shield is from d + 20 (mm) to d + 50 (mm), and the distance Y from the surface of the raw material melt to the lower end of the radiation shield is from 10 to 40 mm.

3. A silicon single crystal obtained by the method according to claim 1, comprising a crystal body having a carbon concentration of at most $1.0 \times 10^{14}$ atoms/cm$^3$ at least by a time when the solidified fraction of the pulled crystal reaches 90%, and having a minimum value on its carbon concentration distribution plotted against the solidified fraction.

4. The silicon single crystal according to claim 3, having an oxygen concentration of at most $1.0 \times 10^{18}$ atoms/cm$^3$.

5. The silicon single crystal according to claim 3, having a minimum value on its carbon concentration distribution plotted against the solidified fraction, wherein the minimum value appears until a time when the solidified fraction reaches 30%.

6. The silicon single crystal according to claim 3, wherein the carbon concentration is determined by a photoluminescence method.

# Fig. 1

## Fig. 2

## Fig. 3

# Fig. 4

# Fig. 5

# Fig. 6

**EP 2 824 222 A1**

Europäisches
Patentamt
European
Patent Office
Office européen
des brevets

# EUROPEAN SEARCH REPORT

Application Number

EP 14 17 6279

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | JP H07 89789 A (FUJITSU LTD) 4 April 1995 (1995-04-04) * figure 2 * | 3,5,6 | INV. C30B15/20 C30B15/30 C30B27/02 C30B29/06 C30B30/04 |
| X | JP 2008 297132 A (SUMCO CORP) 11 December 2008 (2008-12-11) * figure 2 * | 3,5,6 | |
| X | JP 2009 018967 A (SHARP KK) 29 January 2009 (2009-01-29) * paragraph [0048] * | 3-6 | |
| X | EP 2 426 085 A1 (WACKER CHEMIE AG [DE]) 7 March 2012 (2012-03-07) * examples 1, 2; table 1 * | 3,5,6 | |
| A | WO 2009/025337 A1 (SUMCO CORP [JP]; UMENO SHIGERU [JP]; ONO TOSHIAKI [JP]; NISHIMOTO MANA) 26 February 2009 (2009-02-26) * the whole document * | 1-6 | |
| A | US 2009/224367 A1 (KURITA KAZUNARI [JP] ET AL) 10 September 2009 (2009-09-10) * the whole document * | 1-6 | TECHNICAL FIELDS SEARCHED (IPC) C30B |
| A,P | Yuta Nagai ET AL: "science24.com - Crystal growth of MCZ silicon with ultra low carbon concentration", 17th International Conference on Crystal Growth and Epitaxy - ICCGE-17, 14 August 2013 (2013-08-14), pages 1-3, XP055152011, 17th International Conference on Crystal Growth and Epitaxy - ICCGE-17, 2013 Warsaw, Poland Retrieved from the Internet: URL:http://science24.com/paper/29506 [retrieved on 2014-11-10] * the whole document * | 1-6 | |

The present search report has been drawn up for all claims

| Place of search | Date of completion of the search | Examiner |
|---|---|---|
| The Hague | 10 November 2014 | Schmitt, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

16

## ANNEX TO THE EUROPEAN SEARCH REPORT
## ON EUROPEAN PATENT APPLICATION NO.

EP 14 17 6279

This annex lists the patent family members relating to the patent documents cited in the above-mentioned European search report.
The members are as contained in the European Patent Office EDP file on
The European Patent Office is in no way liable for these particulars which are merely given for the purpose of information.

10-11-2014

| Patent document cited in search report | | Publication date | Patent family member(s) | | Publication date |
|---|---|---|---|---|---|
| JP H0789789 | A | 04-04-1995 | NONE | | |
| JP 2008297132 | A | 11-12-2008 | JP | 4957385 B2 | 20-06-2012 |
| | | | JP | 2008297132 A | 11-12-2008 |
| JP 2009018967 | A | 29-01-2009 | NONE | | |
| EP 2426085 | A1 | 07-03-2012 | CA | 2749641 A1 | 06-03-2012 |
| | | | CN | 102432017 A | 02-05-2012 |
| | | | DE | 102010040293 A1 | 08-03-2012 |
| | | | EP | 2426085 A1 | 07-03-2012 |
| | | | ES | 2427441 T3 | 30-10-2013 |
| | | | JP | 5485238 B2 | 07-05-2014 |
| | | | JP | 2012056836 A | 22-03-2012 |
| | | | KR | 20120025995 A | 16-03-2012 |
| | | | US | 2012058040 A1 | 08-03-2012 |
| WO 2009025337 | A1 | 26-02-2009 | JP | 5321460 B2 | 23-10-2013 |
| | | | WO | 2009025337 A1 | 26-02-2009 |
| US 2009224367 | A1 | 10-09-2009 | EP | 2112254 A2 | 28-10-2009 |
| | | | KR | 20090095514 A | 09-09-2009 |
| | | | TW | 200947561 A | 16-11-2009 |
| | | | US | 2009224367 A1 | 10-09-2009 |

EPO FORM P0459

For more details about this annex : see Official Journal of the European Patent Office, No. 12/82

# EP 2 824 222 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 7089789 A

- JP 5339093 A

### Non-patent literature cited in the description

- **S. NAKAGAWA ; K. KASHIMA ; M. TAJIMA.** *Proceedings of the Forum on the Science and Technology of Silicon Materials,* 2010, 326